(19) Europäisches Patentamt
European Patent Office
Office européen des brevets

(11) **EP 1 679 797 B1**

(12) **EUROPEAN PATENT SPECIFICATION**

(45) Date of publication and mention
of the grant of the patent:
**09.09.2009 Bulletin 2009/37**

(51) Int Cl.:
*H03K 19/003* (2006.01)    *H03K 17/16* (2006.01)

(21) Application number: **05028707.7**

(22) Date of filing: **30.12.2005**

(54) **A low noise output buffer capable of operating at high speeds**

Schnelle Ausgangspufferschaltung mit niedriger Störspannung

Circuit tampon de sortie à faible bruit opérant à grande vitesse

(84) Designated Contracting States:
**DE FR GB IT**

(30) Priority: **31.12.2004 IN DE26152004**

(43) Date of publication of application:
**12.07.2006 Bulletin 2006/28**

(73) Proprietor: **STMicroelectronics Pvt. Ltd**
**Noida-201 301, Uttar Pradesh (IN)**

(72) Inventors:
• **Gupta, Ranjeet**
  **Vaishali Ghaziabad, U.P. (IN)**
• **Garg, Paras**
  **Noida, 201301 UP (IN)**

(74) Representative: **Ferrari, Barbara**
  **Botti & Ferrari S.r.l.,**
  **Via Locatelli, 5**
  **20124 Milano (IT)**

(56) References cited:
**EP-A- 0 485 918        US-A- 4 752 703**
**US-A1- 2003 025 541**

**Description**

Field of the Invention

The present invention relates to a low noise output buffer capable of operating at high speeds.

Background of the Invention

Noise in the power supplies is one of the major concerns while designing high-speed digital and analog I/O circuits.

As it is well known, one of the major sources of supply noise is the switching of output drivers of I/O circuits. The faster the I/O circuit is, more current it requires and that implies higher noise. This may cause functional failures on an integrated chip comprising such an I/O circuit. So, the check on the noise has become a main concern while designing high-speed output drivers of I/O circuits.

Furthermore, it should be noted that as CMOS devices are scaled down into the deep sub-micron region, the operating frequency of the output drivers is increased (e.g. frequencies over 50 MHz), which is reflected in terms of reduction in rise/fall times and pulse widths. High switching speed leads to fast rate of change of current (di/dt).

In particular, it is known that s Simultaneous Switching Noise (SSN) is created when many output drivers connected to a single supply reference simultaneously switch in presence of chip-package interface power distribution parasitic. This SSN should be limited within a maximum allowable noise level to guarantee normal functioning of the output driver buffers and the devices connected to same supply reference.

Therefore, power and ground noises have to be controlled for reliable operation of the logic devices connected thereto.

Some of the encountered problems with incorrect operations due to SSN are false triggering, double clocking and/or missing clocked pulses.

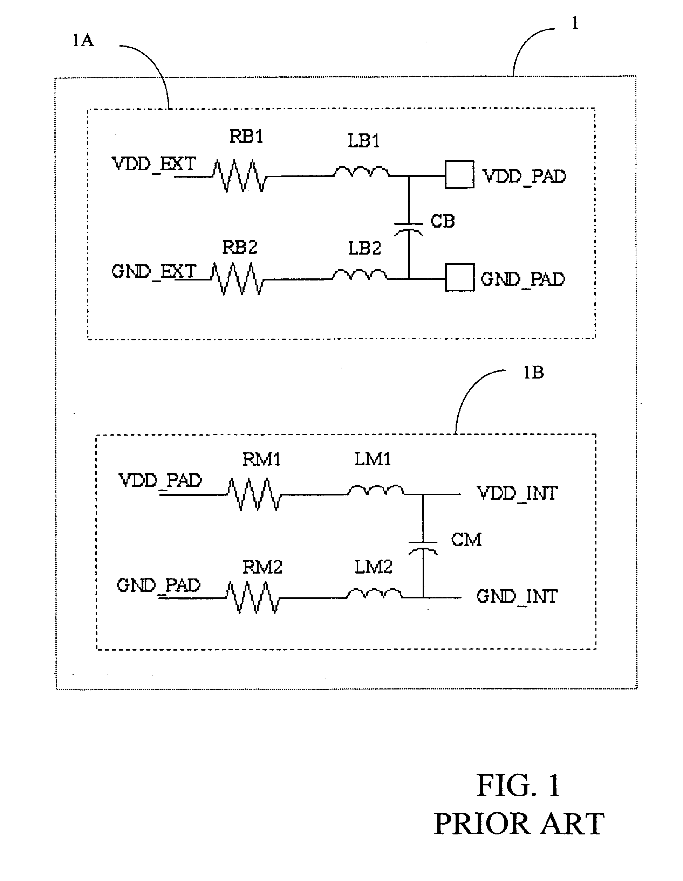

A typical chip-package interface realised according to the prior art is shown in FIGURE 1, schematically and globally indicated at 1.

The interface 1 comprises a first 1A and a second buffer 1B, substantially equivalent to each other. In particular, the first buffer 1A connects a first and second external voltage references, in particular an external supply reference VDD_EXT and an external ground reference GND_EXT, to a first and a second pads, in particular a supply pad VDD_PAD and a ground pad GND_PAD, while the second buffer 1B connects the supply pad VDD_PAD and the ground pad GND_PAD to a first and second internal voltage references, in particular an internal supply reference VDD_INT and an internal ground reference GND_INT.

The first buffer 1A comprises a first trace and bonding wire resistor RB 1 and a first trace and bonding wire inductor LB 1 inserted, in series to each other, between the external supply reference VDD_EXT and the supply pad VDD_PAD as well as a second trace and bonding wire resistor RB2 and a second trace and bonding wire inductor LB2 inserted, in series to each other, between the external ground reference GND_EXT and the ground pad GND_PAD. Moreover, the first buffer 1A comprises a trace and bonding wire capacitor CB inserted between the supply pad VDD_PAD and the ground pad GND_PAD.

In an analogous manner, the second buffer 1B comprises a first metal rail interconnection resistor RM 1 and a first metal rail interconnection inductor LM 1 inserted, in series to each other, between the supply pad VDD_PAD and the internal supply reference VDD_INT as well as a second metal rail interconnection resistor RM2 and a second metal rail interconnection inductor LM2 inserted, in series to each other, between the ground pad GND_PAD and the internal ground reference GND_INT. Moreover, the second buffer 1B comprises a metal rail interconnection capacitor CM inserted between the internal supply reference VDD_INT and the internal ground reference GND_INT.

In a general form, the voltage bounce Vbounce of the supply and ground references - which is due to SSN - can be written as

$$\text{Vbounce} = n * L * di/dt \qquad (1)$$

Where n is the number of buffers switching together, L is the cumulative inductance of the corresponding trace, bonding wire and metal rail interconnections and di/dt is the rate of change of current of a corresponding output driver, which current flows through the supply and ground pads.

As the parameter n and L are not freely changeable (due to the limitation from packaging), the only quantity that can be controlled is the current slew rate for controlling supply/ground noise.

Starting from the above equation (1), it can be seen that the supply noise can be suppressed by reducing the rate of change of charging and discharging current at the load connected to an output driver final stage of the interface. Moreover, the rate of change of charging/ discharging can be monitored by controlling the signals connected to gate terminals of output driver transistors and/or using appropriate sized output driver transistors. The sizes of output driver transistors are fixed due to the output impedance matching requirement with that of the characteristic impedance of the transmission line or output drive specification for driving the TTL/CMOS load.

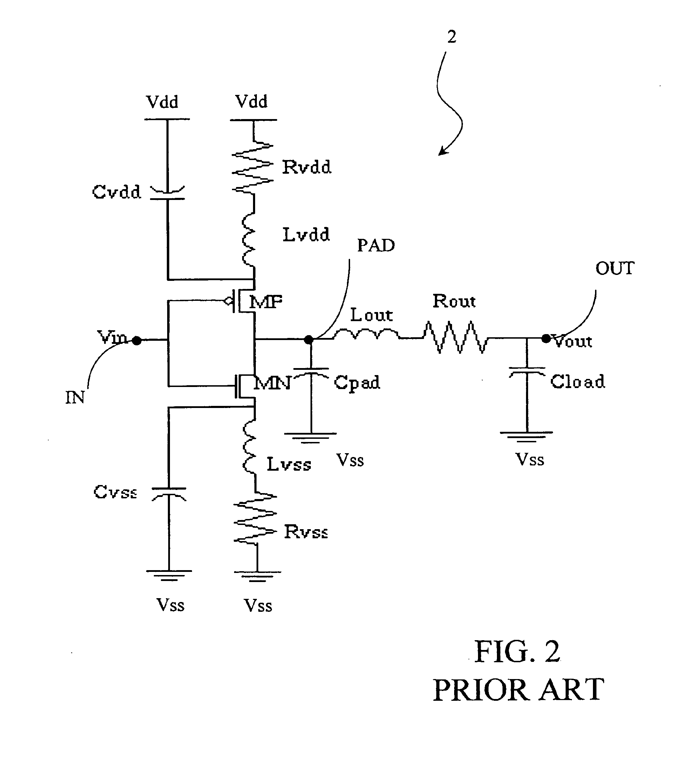

An equivalent circuit of a known output driver final stage is schematically shown in FIGURE 2, globally indicated at 2.

In particular, the output driver final stage 2 is inserted between a first or high voltage reference Vdd and a second or low voltage reference Vss and has an input terminal IN receiving an input voltage signal Vin and an output terminal OUT issuing an output voltage signal Vout and being connected to a load, indicated by means of its equivalent capacitor Cload.

The output driver final stage 2 comprises a first transistor MP, of the PMOS type, and a second transistor MN, of the NMOS type, being in series to each other and having control or gate terminals connected to the input terminal IN and being interconnected to a pad terminal PAD, in turn connected to the output terminal OUT by means of a series of an output inductor Lout and an output resistor Rout, as well as to the low voltage reference Vss by means of a pad capacitor Cpad.

More particularly, the first transistor MP has a first conduction terminal connected to the high voltage reference Vdd by means of a series of a high inductor Lvdd and a high resistor Rvdd and a second conduction terminal connected to a first conduction terminal of the second transistor MN having in turn a second conduction terminal connected to the low supply reference Vss by means of a series of a low inductor Lvss and a low resistor Rvss.

The output driver final stage 2 also comprises a high capacitor Cvdd inserted between the first conduction terminal of the first transistor MP and the high voltage reference Vdd as well as a low capacitor Cvss inserted between the second conduction terminal of the second transistor MN and the low voltage reference Vss.

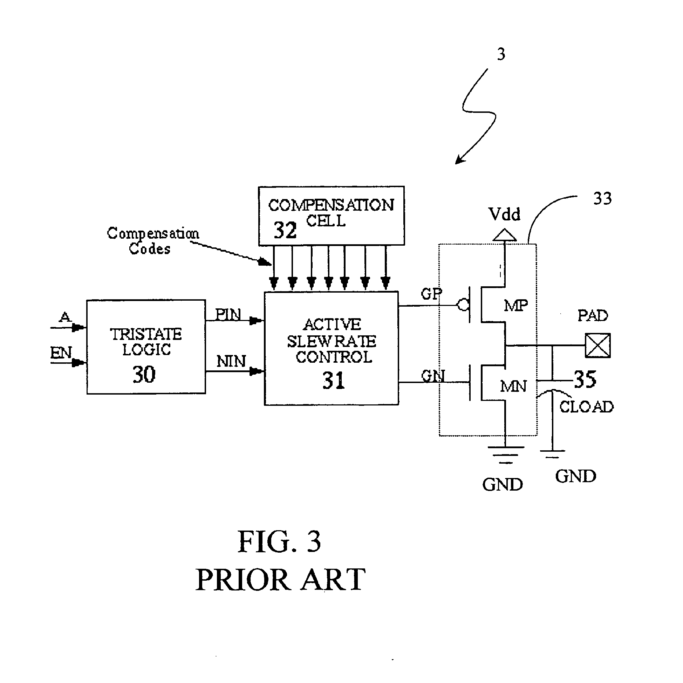

Also known is a compensated CMOS output buffer as schematically shown in FIGURE 3, globally indicated at 3.

The compensated output buffer 3 comprises an output driver 33 formed by a first MP and a second transistor MN, inserted between a first or supply reference Vdd and a second or ground reference GND. More particularly, the compensated output buffer 3 comprises a tri-state logic 30 connected in series to an active slew rate control 31, in turn connected to the transistors MP and MN of the output stage 33.

In particular, the tri-state logic 30 has a first input terminal receiving an input signal A and a second input terminal receiving an enable signal EN as well as a first output terminal connected to a first input terminal of the active slew rate control 31 and transmitting thereto a first logic signal PIN and a second output terminal connected to a second input terminal of the active slew rate control 31 and transmitting thereto a second logic signal NIN. The active slew rate control 31 has in turn a first output terminal connected to a gate terminal of the first transistor MP of the output driver 33 and transmitting thereto a first control signal GP and a output terminal connected to a gate terminal of the second transistor MN of the output driver 33 and transmitting thereto a second control signal GN.

The first and second transistors, MP and MN, of the output driver 33 are interconnected to each other in correspondence to a pad terminal PAD, in turn connected to the ground reference GND by means of a load capacitor CLOAD.

The compensated output buffer 3 also comprises a compensation cell 32 connected to the active slew rate control 31 and providing thereto a plurality of control codes.

The compensated output buffer 3 provides for the compensation of the output driver 33 for slew rate at the rising edge only. A slew rate control circuit according to this known compensation technique is described for instance in the US Patent Application No. US 2003/0025541 published on February 6, 2003 in the name of Humphrey et al.

Generally, a pre-driver is used for controlling the slope of the control signals GP and GN connected to gate terminals of the transistors MP and MN of the output driver 33 by which the slew rate on the rising edge can be controlled while the slew rate on the falling edge can be controlled by sizing of output driver transistors.

However, it should be noted that in case of high speed buffers, the output current is quite high due to the low output impedance of the output driver when the pad terminal PAD is at an high or VOH & a low or VOL logic voltage levels and falls abruptly when the input signal transits. In particular, when the input signal makes a transition from the low logic voltage level to the high one, current at the load starts rising first and then starts falling gradually as the PMOS transistor MP of the output driver 33 goes in linear region.

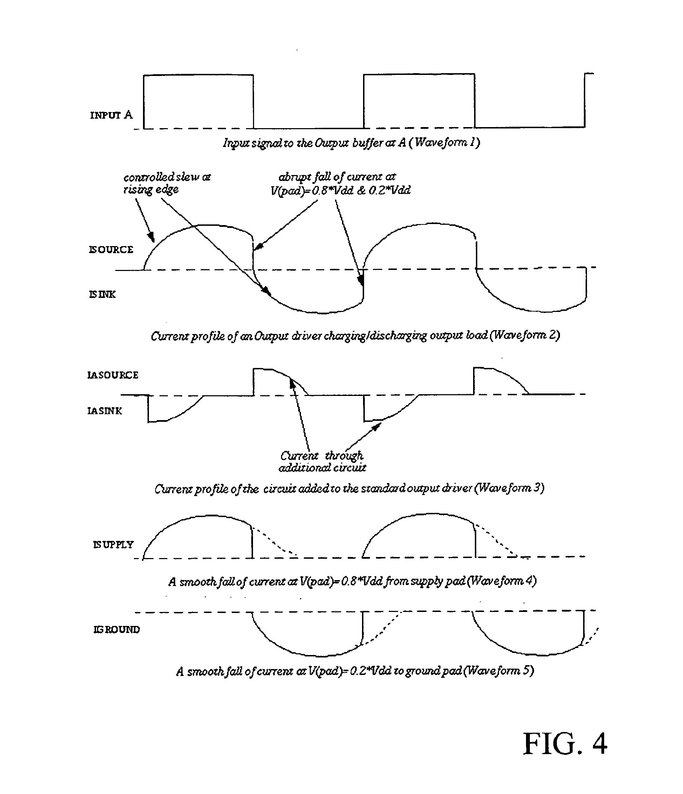

Also, the voltage level at the pad terminal PAD starts rising and reaches the required low logic level VOH but there is an abrupt fall in the current due to change in logic of the input signal (from high to low) of the buffer, as shown in waveform 2 of FIGURE 4. This steep fall of current from an high value to zero when the PMOS transistor MP goes off at the falling edge of the current creates noise due to high value of slew rate when many output buffers switch together.

Also known from the EP patent application No. EP 0 485 918 published on May 20, 1992 in the name of GTE Laboratories Inc. is a method and apparatus for digital switching of FM signals with reduced crosstalk.

In particular, high-speed I/O buffers require delicate handling of the noise on the supply buffers; this requires the control of current slew rate not only on the rising edge of current but also on the falling edge of the current. Thus a circuit providing slew rate limitation at the raising and falling edges of an input signal is required.

The technical problem underlying the present invention is that of providing a low noise output buffer capable of operating at high speeds and having structural and functional characteristics which allow to smooth current transition as seen by the supply so that di/dt of the current flowing through supply is not big enough, in this way overcoming the limits which still affect the devices realised according to the prior art.

## Summary of the Invention

The solution idea underlying the present invention is that of controlling the slew rate at the falling edge of a current signal of a output driver by using an additional circuit connected to the output driver, the obtained low noise output buffer being capable of operating at high speeds.

On the basis of such solution idea the technical problem is solved by a low noise output buffer as previously indicated and defined by the characterising part of claim 1.

The characteristics and advantages of the low noise output buffer according to the invention will be apparent from the following description of embodiments thereof given by way of indicative and non limiting example with reference to the annexed drawings.

## Brief Description of the Drawings

In the drawings:

FIGURE 1 schematically shows a known chip package interface.

FIGURE 2 schematically shows a known output driver final stage equivalent circuit.

FIGURE 3 schematically shows a known compensated CMOS output driver.

FIGURE 4 schematically shows waveforms of internal signals to be obtained by the low noise output buffer according to invention.

FIGURE 5 schematically shows a low noise output buffer according to the invention.

FIGURE 6 shows in greater detail the low noise output buffer of FIGURE 5.

FIGURES 7A-7C show the results of a simulation of the low noise output buffer according to the invention in comparison with an output buffer realised according to the prior art.

## Detailed description

The present invention starts from the consideration that a correct operating of an output buffer should sense the changes in a logic level of an input signal (as shown as waveform 1 in FIGURE 4) and trigger on when its output driver transistors goes off.

In particular, FIGURE 4 shows the waveforms of a low noise output buffer realised according to the invention. The waveform 1 corresponds to an input signal INPUT A of the low noise output buffer, corresponding to an input signal A of an input logic block of the low noise output buffer, corresponding for instance to the tri-state logic 30 described with reference to the compensated output buffer 3 according to the prior art. The waveform 2 corresponds to a current profile of an output driver of the low noise output buffer while charging or discharging a load connected to the low noise output buffer, in particular a source current ISOURCE and a sink current ISINK of the transistors comprised in such output driver. The waveform 3 corresponds to a current profile of an additional circuit for limiting slew rate at the falling edge of the input signal (as will be clear in the following description), in particular a source current IASOURCE and a sink current IASINK of the transistors comprised in such additional circuit. The waveforms 4 and 5 refer to the smooth curves obtained at source/sink regions of the transistors of the output driver of the low noise output buffer according to the invention thanks to the additional circuit. In particular, the waveform 4 is a smooth fall of a current ISUPPLY from a first or supply voltage reference VDD when a voltage level Vpad of a pad terminal PAD of the low noise output buffer is at a value equal to 0.8*VDD and the waveform 5 is a smooth fall of a current IGROUND from a second or ground reference GND when the voltage level Vpad is at a value equal to 0.2*VDD.

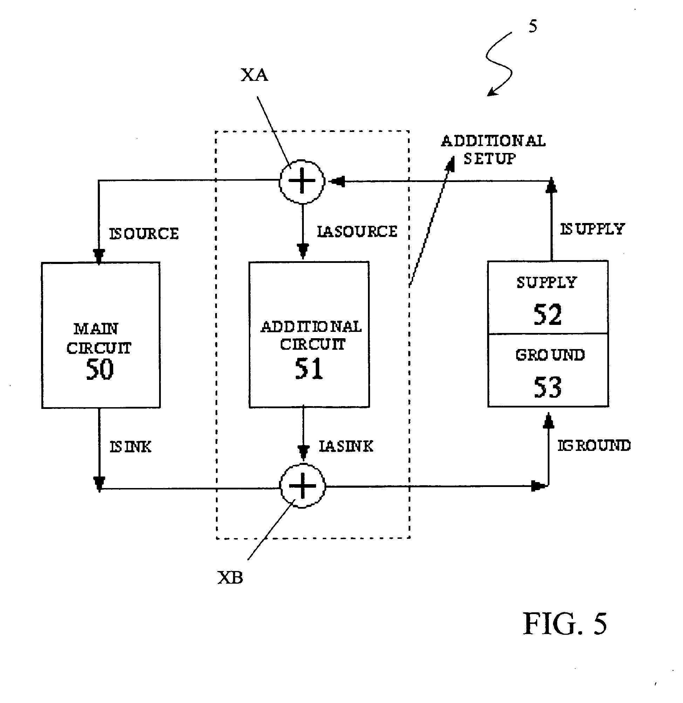

A low noise output buffer according to the invention is schematically shown in FIGURE 5, globally indicated at 5.

The low noise output buffer 5 comprises a main circuit 50 connected in parallel to an additional circuit 51, which provides slew rate limitation at the raising and falling edges of an input signal of the low noise output buffer 5, inserted between the first or supply reference VDD, also indicated with 52 and the second or ground reference GND, also indicated with 53.

It should be noted that the main circuit 50 is basically a circuital portion for which the slew rate at the raising and falling edges of the input signal is to be controlled.

Both the main circuit 50 and the additional circuit 51 are connected to the supply and ground references 52 and 53 for sourcing or sinking current. In particular a first summing node XA of the additional circuit 51 receives a first current ISUPPLY from the supply voltage reference VDD and provides a first and a second source current, ISOURCE and IASOURCE to the main circuit 50 and to the additional circuit 51, respectively, while a second summing node XB of the additional circuit 51 receives a first and a second sink current, ISINK and IASINK from the main circuit 50 and the additional circuit 51, respectively and provides a second current IGROUND to the ground voltage reference GND. The additional circuit 51 is a current bypass circuit.

When an input signal A (waveform 1 of FIGURE 4) is applied, the current in the main circuit 50 starts rising and follows the trajectory as shown in waveform 2 of FIGURE 4. It can be seen from the waveform 2 that the slew rate is controlled at the rising edge using a compensation cell, as in the prior art circuit. As soon as the input signal A (waveform 1 of FIGURE 4) transits from a high to a low level, to avoid an abrupt fall of the current, the additional circuit 51 comes into play with current profile as shown in waveform 3 of FIGURE 4. In particular, as will be clear from the following description, the additional circuit 51 provides an alternate path to the supply current ISUPPLY and therefore removes the possibility of an abrupt transition of the current.

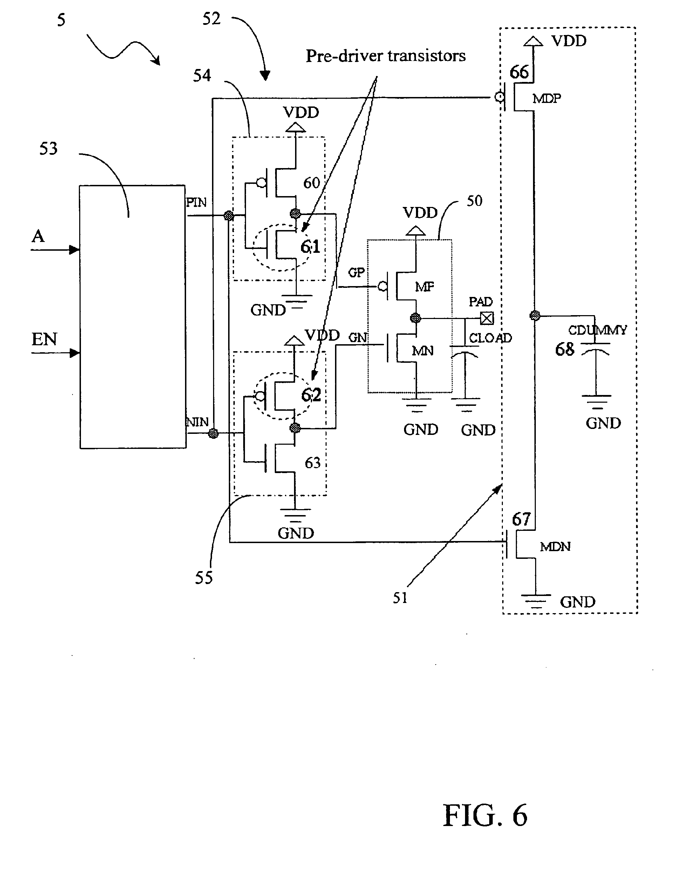

An embodiment of the low noise output buffer 5 according to the invention is schematically shown in FIGURE 6. To structurally and/or functionally equal elements with respect to the buffer described in the prior art section, same reference numbers will be applied.

The low noise output buffer 5 comprises an output driver 50 inserted between the first or supply voltage reference VDD and the second or ground voltage reference GND and comprising the series of a first transistor MP of the PMOS type and a second transistor MN of the NMOS type being interconnected to each other and to an output or pad terminal PAD of the low noise output buffer 5, in turn connected to the ground voltage reference GND by means of a load capacitor CLOAD, as described with reference to the prior art.

The output driver 50 corresponds to the main circuit for which the slew rate at the raising and falling edges of the input signal is to be controlled by a slew rate control circuit 52 connected thereto.

The slew rate control circuit 52 is in turn connected to an input logic block 53 which receives an input A and an enabling signal EN and provides to the slew rate control circuit 52, in a known manner, a first and second logic signals, PIN and NIN, which are delayed version of the input signal A.

Advantageously according to the invention, the slew rate control circuit 52 comprises an additional circuit 51 also connected to a first and a second output terminals of the input logic block 53 and receiving the first and second logic signals, PIN and NIN, therefrom.

More particularly, the slew rate control circuit 52 comprises a first pre-driver buffer 54, inserted between the supply and ground voltage references, VDD and GND, and in turn comprising a first and second pre-driver transistors, 60 and 61.

The first and second pre-driver transistors, 60 and 61, are of the PMOS and NMOS type, respectively, have their control or gate terminals connected to the first output terminal of the input logic block 53 and are interconnected to each other and to a control or gate terminal of the first output driver transistor MP, which receives a first control signal GP.

The slew rate control circuit 52 also comprises a second pre-driver buffer 55, inserted between the supply and ground voltage references, VDD and GND, and in turn comprising a third and fourth pre-driver transistors, 62 and 63.

The third and fourth pre-driver transistors, 62 and 63, are of the PMOS and NMOS type, respectively, have their control or gate terminals connected to the second output terminal of the input logic block 53 and are interconnected to each other and to a control or gate terminal of the second output driver transistor MN, which receives a second control signal GN.

For sake of simplicity, the terminals and the signals applied thereto will be indicate by the same reference.

Advantageously according to the invention, the slew rate control circuit 52 also comprises the additional circuit 51, in turn including a first and a second additional transistors, MDP or 66 and MDN or 67, inserted, in series to each other, between the supply and ground voltage references, VDD and GND and interconnected to each other and to the ground voltage reference GND by means of an additional capacitor CDUMMY or 68.

In particular, the first additional transistor 66 is of the PMOS type and has a control or gate terminal connected to the second logic terminal NIN, while the second additional transistor 67 is of the NMOS type and has a control or gate terminal connected to the first logic terminal PIN.

The operation of the low noise output buffer 5 according to the invention is as follows.

When the enabling terminal EN is at an high logic value, HIGH, the output driver 50 is tri-stated by the input logic block 53, the first logic terminal PIN goes low (the first gate terminal GP thus going high) and the second logic terminal NIN goes high (the second gate terminal GN going low).

Advantageously according to the invention, the gate terminals, GP and GN, of the output driver transistors, MP and MN, are controlled for slew control at the raising edge of the input signal using the second and third pre-driver transistors, 61 and 62. When the output driver PMOS transistor MP is ON (corresponding to a high value of the input signal A), the first gate terminal GP is controlled (slowly decreased) to control the slew rate at the rising edge. In the same way, the second gate terminal GN is controlled when the output driver NMOS transistor MN is ON.

So when the input signal A changes from high to low, i.e. the first gate terminal GP goes from low to high, the output driver PMOS transistor MP goes off and being very high drive, current falls abruptly from high value to zero.

To avoid the abrupt change in the current from the supply voltage reference VDD, the first additional PMOS transistor 66 of the additional circuit 51 is turned on using the second logic terminal NIN that goes low (when the first gate terminal GP goes high) while the falling of the current from the supply voltage reference is controlled by charging the additional capacitor 68 of the additional circuit 51.

The same process is followed when the input signal A goes low and the second additional NMOS transistor 67 of the additional circuit 51 turns on to discharge the additional capacitor 68.

So, the first and second additional transistors 66 and 67 allows a control of the slew rate at the falling edge of the input signal A of the low noise output buffer 5.

The sizes of the additional transistors 66 and 67 and of the additional capacitor 68 are calculated using simple analysis.

In a preferred embodiment of the invention, the low noise output buffer 5 is designed to operate at 55 MHz with a capacitive load of 80pf and with the specifications on the output driver 50 as a maximum slew rate equal to 20 mA/ns and an output impedance equal to 50 ohm.

Specified values of the high and low voltage levels, VOH and VOL, are 0.8*Vdd and 0.2*Vdd respectively.

According to this preferred embodiment, the peak current of the additional transistors 66 and 67 can be set to the same value of the output current when the input signal A makes a transition i.e. when the voltage VPAD at the pad terminal PAD crosses the high voltage level VOH for the first additional transistor 66 and the low voltage level VOL for the second additional transistor 67.

The value of the additional capacitor 68 can be set for the desired falling slew rate of the supply current ISUPPLY from the supply voltage reference VDD.

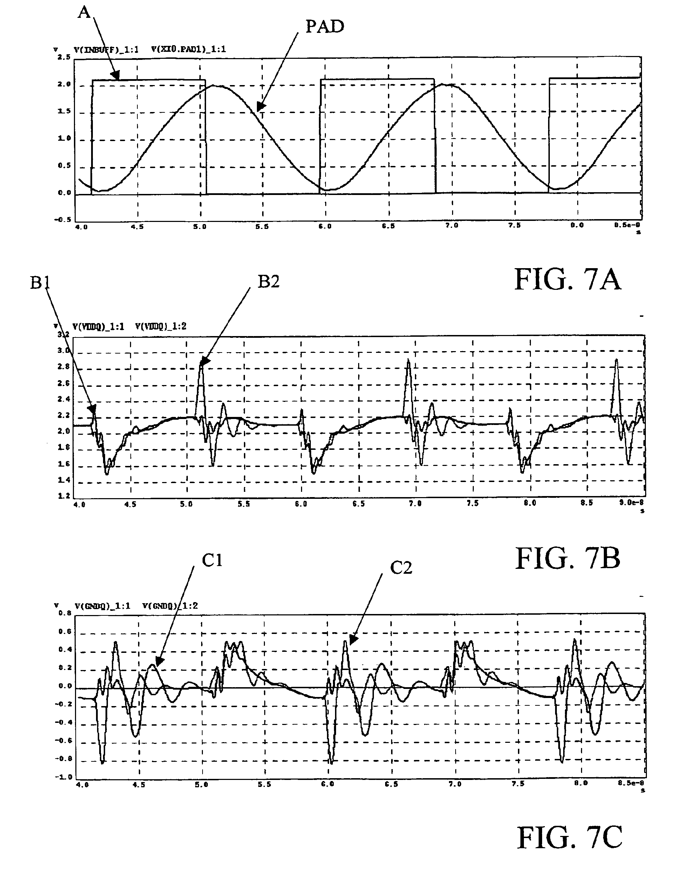

The Applicant has performed a simulation of the low noise output buffer 5 according to the preferred embodiment of the invention (at 55MHz and 80pf load) in comparison with an output buffer realised according to the prior art, the results being shown in FIGURES 7A-7C.

From the analysis of such results it is clear that the output buffer 5 allows a noise reduction.

In particular, FIGURE 7A a pulse input signal (A) and a corresponding output signal (PAD) of output drivers of the low noise output buffers according to the invention and to the prior art.

FIGURE 7B shows the noise affecting the supply voltage reference VDD (in particular equal to 2.1V) with (line B1) and without (line B2) using additional circuit. It can be seen that there is not much of a difference in the noise at the rising edge but the noise at falling edge is drastically reduced by using the low noise output buffer 5 according to the invention.

In an analogous manner, FIGURE 7C shows the noise affecting the ground voltage reference with (line C1) and without (line C2) additional circuit. Also in this case, a difference in the noise at the falling edge of the current can be seen. The results have also been tabulated in the following Table 1.

Table 1: Supply/ ground noise comparison

|  | Bounce/drop(max) with add. ckt | Bounce/drop(max) without add. ckt |
|---|---|---|
| Vdd bounce/drop | 0.55 V | 0.81 V |
| Gnd bounce/drop | 0.52 V | 0.84 V |

In essence, using the low noise output buffer 5 according to the invention which advantageously comprises the additional circuit 51, at lower frequencies the output driver current has enough time to come down to low value. This creates a small spike of current due to the additional circuit 51 which adds a bounce to the supply voltage reference, but it is insured that such an additional created bounce is not going to effect the normal operation as the level of the additional bounce is lower than the bounce created by the rising edge slew of the current.

Looking at the results, it can be concluded that the low noise output buffer according the present invention provide a very effective control of the slew rate if the output driver is used at a predetermined frequency.

However, its should be noted that the proposed low noise output buffer has been designed for worst case where the effect of noise on the driver is maximum.

It is clear that the proposed low noise output buffer can be also compensated using digital codes from a compensation cell (as explained with reference to the prior art) to make if even more effective at the slow corners. The proposed low noise output buffer thus allows to increase operating frequency without increasing the supply/ ground bounce.

In summary, advantageously according to the invention, the proposed low noise output buffer is capable of operating at high speeds, allowing a smooth current transition as seen by the supply so that di/dt of the current flowing through supply is not big enough. An additional circuit is added to the output buffer circuit that turns on as soon as either of transistors of the output driver turns off abruptly due to change in the input logic signal. Thus the additional current in bypass circuit adds to the current flowing through output driver to make it smooth as seen by the supply pad.

In particular, the low noise output buffer according to the invention obtain a control of the current slew rate on raising and falling edges of an input signal of an output driver charging/discharging heavy load without affecting the speed of the driver, which otherwise would have created supply/ground bounce due to parasitic elements present in the bonding wires, package pins and on-chip metal interconnects in the IO ring.

According to the embodiment of the invention shown in FIGURE 6, the proposed simple circuital architecture for the low noise output buffer suppresses the supply/ground noise by a very significant level while incurring small penalty in terms of silicon area and power dissipation.

**Claims**

1. A low noise output buffer (5) capable of operating at high speeds inserted between first and second voltage references (VDD, GND) and comprising a main circuit (50) including an output buffer (50) inserted between said first and second voltage references (VDD, GND) and comprising the series of a first transistor (MP) and a second transistor (MN) being interconnected to each other and to an output terminal (PAD) of said low noise output buffer (5), in turn connected to the said second voltage reference (GND) by means of a load capacitor (CLOAD), and being connected to a slew rate control circuit (52), in turn inserted between said first and second voltage references (VDD, GND) and comprising first and second pre-driver buffers (54, 55), inserted between said first and second voltage references (VDD, GND) and having first and second input logic terminals (PIN, NIN) receiving logic signals , which are delayed versions of said input signal (A) and being connected to control terminals of said first and second transistors (MP, MN) of said output driver (50), said first pre driver buffer (54) comprising first and second pre-driver transistors (60, 61), which have their control terminals connected to said first logic terminal (PIN) and are interconnected to each other and to a control terminal of said first transistor (MP) of said output driver (50), thus providing a first control signal (GP) thereto and said second pre-driver buffer (55) comprising a third and fourth pre-driver transistors (62, 63), which have their control terminals connected to said Second logic terminal (NIN) and are interconnected to each other and to a control terminal of said second transistor (MN) of said output driver (50), thus providing a second control signal (GN) thereto **characterised in that** said slew rate control circuit (52) comprises an additional circuit (51) connected to said main circuit (50) and comprising a first and a second additional transistors (66, 67), inserted, in series to each other, between said first and second voltage references (VDD, GND) and interconnected to each other, and to said second voltage reference (GND) by means of an additional capacitor (68), said first additional transistor (66) having a control terminal connected to said second logic terminal (NIN), and said second additional transistor (67) having a control terminal connected to said first logic terminal (PIN)for receiving said logic signals (NIN, PIN), which are delayed signals of said input signal (A) in such a way that said first additional transistor (66) is turned on when said first transister (MP) is is turned off, and said second additional transistor (67) is turned on when said second transistor (MN) is turned off, thus charging/discharging said additional capacitor (68).

2. The low noise output buffer as claimed in claim 1 wherein said additional transistors are MOS transistors.

3. The low noise output buffer as claimed in claim 1 wherein said additional transistors are CMOS transistors.

**Patentansprüche**

1. Rauscharmer Ausgangspuffer (5), der zum Betrieb bei hohen Geschwindigkeiten fähig ist, der zwischen einer ersten und einer zweiten Spannungsreferenz (VDD, GND) eingefügt ist und eine Hauptschaltung (50) aufweist, die einen Ausgangspuffer (50) aufweist, der zwischen der ersten und der zweiten Spannungsreferenz (VDD, GND) eingefügt ist und eine Reihenschaltung eines ersten Transistors (MP) und eines zweiten Transistors (MN) aufweist, die miteinander und mit einem Ausgangsanschluss (PAD) des rauscharmen Ausgangspuffers (5) verbunden sind, der wiederum mittels eines Lastkondensators (CLOAD) mit der zweiten Spannungsreferenz (GND) verbunden ist, und mit einer Flankensteilheitssteuerschaltung (52) verbunden ist, die wiederum zwischen der ersten und der zweiten Spannungsreferenz (VDD, GND) eingefügt ist und einen ersten und einen zweiten Vortreiberpuffer (54, 55) aufweist, die zwischen der ersten und der zweiten Spannungsreferenz (VDD, GND) eingefügt sind, einen ersten und einen zweiten Eingangslogikanschluss (PIN, NIN) haben, die Logiksignale empfangen, die verzögerte Versionen des Eingangssignals (A) sind, und mit Steueranschlüssen des ersten und des zweiten Transistors (MP, MN) des Ausgangstreibers (50) verbunden sind, wobei der erste Vortreiberpuffer (54) einen ersten und einen zweiten Vortreibertransistor (60, 61) aufweist, deren Steueranschlüsse mit dem ersten Logikanschluss (PIN) verbunden sind und die miteinander und mit einem Steueranschluss des ersten Transistors (MP) des Ausgangstreibers (50) verbunden sind, wodurch diesem ein erstes Steuersignal (GP) geliefert wird, und wobei der zweite Vortreiberpuffer (55) einen dritten und einen vierten Vortreibertransistor (62, 63) aufweist, deren Steueranschlüsse mit dem zweiten Logikanschluss (NIN) verbunden sind und die miteinander und mit einem Steueranschluss des zweiten Transistors (MN) des Ausgangstreibers (50) verbunden sind, wodurch diesem ein zweites Steuersignal (GN) geliefert wird, **dadurch gekennzeichnet, dass** die Flankensteilheitssteuerschaltung (52) eine zuätzliche Schaltung (51) aufweist, die mit der Hauptschaltung (50) verbunden ist und einen ersten und einen zweiten zusätzlichen Transistor (66, 67) aufweist, die in Reihe zwischen der ersten und der zweiten Spannungsreferenz (VDD, GND) eingefügt sind, miteinander verbunden sind und mittels eines zusätzlichen Kondensators (68) mit der zweiten Spannungsreferenz (GND) verbunden sind, wobei der erste zusätzliche Transistor (66) einen Steueranschluss hat, der mit dem zweiten Logikanschluss (NIN) verbunden ist, und der zweite zusätzliche Transistor (67) einen Steueranschluss hat, der mit dem ersten Logikanschluss (PIN) verbunden ist, um die Logiksignale (NIN, PIN) zu empfangen, die verzögerte Signale des Eingangssignals (A) sind, so dass der erste zusätzliche Transistor (66) eingeschaltet ist, wenn der erste Transistor (MP) ausgeschaltet ist, und der zweite zusätzliche Transistor (67) eingeschaltet ist, wenn der zweite Transistor (MN) ausgeschaltet ist, wodurch der zusätzliche Kondensator (68) geladen/entladen wird.

2. Rauscharmer Ausgangspuffer nach Anspruch 1, wobei die zusätzlichen Transistoren MOS-Transistoren sind.

3. Rauscharmer Ausgangspuffer nach Anspruch 1, wobei die zusätzlichen Transistoren CMOS-Transistoren sind.

**Revendications**

1. Circuit tampon de sortie à faible bruit (5) opérant à grande vitesse inséré entre une première et une seconde référence de tension (VDD, GND) et comprenant un circuit principal (50) comprenant un circuit tampon de sortie (50) inséré entre la première et la seconde référence de tension (VDD, GND) et comprenant la série constituée par un premier transistor (MP) et un second transistor (MN) étant interconnectés l'un avec l'autre et interconnectés avec une borne de sortie (PAD) du circuit tampon de sortie à faible bruit (5), à sont tour connecté à la seconde référence de tension (GND) au moyen d'un condensateur de charge (CLOAD), et étant connecté à un circuit de contrôle de vitesse de balayage (52), à son tour inséré entre la première et la seconde référence de tension (VDD, GND) et comprenant un premier et un second circuit tampon à pré-circuit de commande (54, 55), insérés entre la première et la seconde référence de tension (VDD, GND) et présentant une première et une seconde borne logique d'entrée (PIN, NIN) recevant des signaux logiques, qui sont des versions différées du signal d'entrée (A) et étant connectées à des bornes de contrôle du premier et du second transistor (MP, MN) du circuit de sortie (50), le premier circuit tampon à pré-circuit de commande (54) comprenant un premier et un second transistor à pré-circuit de commande (60, 61), dont les bornes de contrôle sont connectées à la première borne logique (PIN) et qui sont interconnectés l'un avec l'autre et interconnectés avec une borne de contrôle du premier transistor (MP) du circuit de sortie (50), lui fournissant ainsi un premier signal de contrôle (GP) et le second tampon à pré-circuit de commande (55) comprenant un troisième et un quatrième transistor à pré-circuit de commande (62, 63), dont les bornes de contrôle sont connectées à la seconde borne logique (NIM) et qui sont interconnectés l'un avec l'autre et interconnectés avec une borne de contrôle du second transistor (MN) du circuit de sortie (50), lui fournissant ainsi un second signal de contrôle (GN) **caractérisé en ce que** le circuit de contrôle de vitesse de balayage (52) comprend un circuit supplémentaire (51) connecté au circuit principal (50) et comprenant un premier et un second transistor supplémentaire (66, 67), insérés en série l'un avec l'autre entre la première et la seconde référence de tension (VDD, GND) et interconnectés l'un avec l'autre, et interconnectés avec la seconde référence de tension (GND) au moyen d'un condensateur supplémentaire (68), le premier transistor supplémentaire (66) présentant une borne de contrôle connectée à la seconde borne logique (NIM), et le second transistor supplémentaire (67) présentant une borne de contrôle connectée à la première borne logique (PIN) pour recevoir les signaux logiques ($_{NI}$N, PIN), qui sont des signaux différés du signal d'entrée (A) de telle sorte que le premier transistor supplémentaire (66) est allumé lorsque le premier transistor (MP) est éteint, et le second transistor supplémentaire (67) est allumé lorsque le second transistor (MN) est éteint, chargeant / déchargeant ainsi le condensateur supplémentaire (68).

2. Circuit tampon de sortie à faible bruit selon la revendication 1, dans lequel les transistors supplémentaires sont des transistors MOS.

3. Circuit tampon de sortie à faible bruit selon la revendication 1, dans lequel les transistors supplémentaires sont des transistors CMOS.

FIG. 1
PRIOR ART

FIG. 2
PRIOR ART

FIG. 3
PRIOR ART

INPUT A

*Input signal to the Output buffer at A ( Waveform 1)*

controlled slew at
rising edge

abrupt fall of current at
V(pad)=0.8*Vdd & 0.2*Vdd

ISOURCE

ISINK

*Current profile of an Output driver charging/discharging output load (Waveform 2)*

IASOURCE

IASINK

Current through
additional circuit

*Current profile of the circuit added to the standard output driver (Waveform 3)*

ISUPPLY

*A smooth fall of current at V(pad)=0.8*Vdd from supply pad (Waveform 4)*

IGROUND

*A smooth fall of current at V(pad)=0.2*Vdd to ground pad (Waveform 5)*

# FIG. 4

FIG. 5

FIG. 6

FIG. 7A

FIG. 7B

FIG. 7C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030025541 A

- EP 0485918 A